# EUROPÄISCHE PATENTSCHRIFT

(11) **EP 2 110 749 B1**
(45) Veröffentlichungstag und Bekanntmachung des Hinweises auf die Patenterteilung: **07.01.2015**
(21) Anmeldenummer: 09157952.4
(22) Anmeldetag: 15.04.2009
(51) Int. Cl.: G06F 11/267, G01R 31/3185

(54) **Verfahren zum Steuern von Anschlusspins eines emulationsfähigen Bausteins und Anordnung zur Durchführung des Verfahrens**
Method for controlling connection pins of an emulation-capable component and assembly to carry out the method
Procédé de commande de puces de connexion d'un module pouvant émulsifier et agencement destiné à l'exécution du procédé

(30) Priorität: 17.04.2008 DE 102008019861
(43) Veröffentlichungstag der Anmeldung: 21.10.2009
(73) Patentinhaber: Göpel electronic GmbH, 07745 Jena (DE)
(72) Erfinder: Berger, Mario, 07751 Milda (DE)
(74) Vertreter: Oehmke, Volker

(56) Entgegenhaltungen:
- WO-A2-2006/008721
- DE-A1-102005 039 347
- US-A1- 2006 059 387

## Beschreibung

Die vorliegende Erfindung betrifft ein Verfahren zum Steuern von Anschlusspins eines emulationsfähigen Bausteins, wobei es möglich ist die Anschlusspins über den Zugriff auf ein Boundary Scan Register zu kontrollieren. Mit dem Verfahren ist es möglich, Bausteine in einen Test nach dem Boundary Scan Standard einzubeziehen, was insbesondere für den Test von Leiterplatten wichtig ist.

In dieser Patentschrift werden emulationsfähiger Baustein und Mikroprozessor als Synonym verwendet.

Beim elektrischen Test von komplexen bestückten Leiterplatten haben sich zwei Testverfahren als sehr vorteilhaft erwiesen. Das ist zum einen das Funktionstestverfahren und zum anderen das Boundary Scan Testverfahren.

Als ein Funktionstestverfahren seien hierbei die Verfahren verstanden, welche über den Weg der Emulation über eine Debug Schnittstelle die Umgebung des Mikroprozessors testen. Dies ist in der Patentschrift US 6,842,865 B2 unter dem Begriff "Microprozessor testing using the debug port of the processor" beschrieben. Eine weitere Emulationsmöglichkeit wird in der WO 2006/008721 A2 offenbart. Die prinzipielle Vorgehensweise soll im Folgenden kurz beschrieben werden.
Als eine zwingende Vorraussetzung verfügt der Mikroprozessor über eine Debug Schnittstelle gemäß dem Boundary Scan Standard IEEE1149.1. Er verfügt dabei aber nicht notwendigerweise über das im Standard beschriebene Boundary Scan Register.
Über die Debug Schnittstelle kann der Mikroprozessor gesteuert werden. So kann darüber unter anderem die Abarbeitung des Befehlscode gestoppt und ein neuer Befehlscode eingespeist werden. Eine mögliche Ausführungsform solch einer Schnittstelle sowie die Funktionsweise ist in GB 2 350 215 B und in DE 10 2005 039 347 A1 ausführlich beschrieben. Weiterhin werden solche Debug oder auch Emulationsschnittstellen verwendet, um die auf den Mikroprozessor laufende Software oder Algorithmik zu testen bzw. sogar den Chip selbst. Eine mögliche Ausführungsform hierzu findet sich in US 2006/0059387 A1.

Für den Test der Mikroprozessor Umgebung muss die Umgebung genau bekannt sein. D.h. möchte man z.B. einen an dem Mikroprozessor angeschlossenen RAM Baustein testen, so muss man genau wissen, in welchem Adressraum sich der RAM aus Sicht des Mikroprozessors befindet. Dieser ergibt sich aus dem Aufbau der Baugruppe, genauer aus der Verdrahtung zwischen Mikroprozessor und RAM Baustein. Der Test erfolgt dann über einen dem Fachmann bekannten RAM Test für den Adressraum aus Sicht des Mikroprozessors. Der hierfür notwendige Befehlscode wird über die Debug Schnittstelle an den Mikroprozessor geschickt und dort ausgeführt. Ein RAM Test funktioniert recht einfach und liefert zudem eine recht genaue Diagnose bei einem möglichen Fehler, da es sich lediglich um ein paar Registerzugriffe seitens des Mikroprozessors handelt.

Problematischer wird es dann, wenn die zu testende Mikroprozessor Umgebung sich nicht so einfach beschreiben lässt, d. h. wenn die für den Test notwendige Gegenstelle sehr viel komplexer ausfällt als ein RAM Baustein; genauer gesagt, wenn ein einfacher Register Zugriff nicht ausreicht um eine verwertbare Antwort von der Gegenstelle zu bekommen.

Hier stellt das zweite angesprochene Testverfahren, das Boundary Scan Testverfahren eine sinnvolle Alternative dar. Die Funktionsweise ist in der Patentschrift DE 693 14 683 T2 beschrieben und ergibt sich zudem aus dem zugrunde liegenden Boundary Scan Standard IEEE1149.1: "Test Access Port and Boundary Scan Architecture".

Hierbei verfügen die zu testenden Bausteine über ein zusätzliches Boundary Scan Register, welches einen direkten Zugriff auf die Anschlusspins des Bausteins ermöglicht. Das heißt über das Beschreiben des Boundary Scan Registers können definierte Pegel an den Anschlussbeinchen ausgegeben werden und durch das Lesen des Registers die Pegel gemessen werden. Durch einfache Register Zugriffe kann so die Verbindung zwischen zwei Bausteinen getestet werden.

Als ein wesentlicher Nachteil bedingt das Boundary Scan Testverfahren das Vorhandensein der entsprechenden Strukturen in den Bausteinen, insbesondere des Boundary Scan Registers.

Im Folgenden soll nun davon ausgegangen werden, dass eine Verbindung zwischen einem Mikroprozessor (welcher über eine Debug Schnittstelle gemäß dem Boundary Scan Standard aber nicht über ein Boundary Scan Register verfügt) und einem Baustein gemäß dem Boundary Scan Standard getestet werden soll.

Verfahren nach dem bekannten Stand der Technik arbeiten dabei nach dem folgenden Prinzip: über den oben beschriebenen Weg wird ein Funktionstestprogramm erstellt, welches ein bestimmtes Testmuster an den Anschlusspins des Mikroprozessors ausgibt. Separat dazu wird ein Boundary Scan Testprogramm erstellt, welches die im ersten Schritt bestimmten Testmuster an den Anschlusspins des zweiten, Boundary Scan fähigen Bausteins einliest und überprüft.

Während der Testausführung wird zunächst das Funktionstestprogramm über die Debug Schnittstelle an den Mikroprozessor gesendet und ausgeführt. Anschließend wird das Boundary Scan Testprogramm über eine weitere Schnittstelle am zweiten Baustein ausgeführt.

Auf diesem Weg wird ein vom Mikroprozessor an die Baugruppe geschickter Pegel über einen zweiten Baustein mit der darin befindlichen Boundary Scan Struktur gemessen und überprüft. Die Verbindung zwischen den beiden Bausteinen ist damit überprüft. Meist schließen sich zusätzliche Tests an, z.B. mit invertiertem Pegel oder auch mit umgeschalteter Richtung, um weitere Fehler ausschließen zu können.

Die nach dem eben beschriebenen Prinzip arbeitenden Verfahren haben offensichtlich mehrere Probleme die ihre Ursache in der Kombination von zwei separaten Testverfahren hat. So werden die beiden notwendigen Testprogramme mit zwei unterschiedlichen Softwarewerkzeugen erstellt. Der Anwender hat sich somit darum zu kümmern, dass die bestimmten Testmuster in beiden Softwarewerkzeugen identisch sind. Die Aufgabe der Synchronisation zwischen den beiden Testverfahren obliegt damit einzig und allein ihm. Auch steigt der Aufwand mit jedem neuen Testmuster enorm an und ebenso die möglichen Fehlerquellen bei der Testprogramm Erstellung. Zudem muss sich der Anwender selbst darum kümmern, welcher Anschlusspin des Mikroprozessors mit welchem Anschlusspin des Boundary Scan Bausteins verbunden ist. Dies stellt eine weitere Fehlerquelle dar.

Der Erfindung liegt die Aufgabe zugrunde eine Möglichkeit zu finden, so dass die Unzulänglichkeiten überwunden werden und der Funktionstest als integrativer Bestandteil des Boundary Scan Testverfahrens eingebunden wird.

Erfindungsgemäß wird diese Aufgabe mit einem Verfahren zum Steuern von Anschlusspins eines emulationsfähigen Bausteins mittels eines Computers und einer Boundary Scan Steuereinheit dadurch gelöst, dass Mittel verwendet werden, die die Funktionen einer Boundary Scan Logik und eines Boundary Scan Registers nachbilden, so dass der emulationsfähige Baustein für Prüfzwecke voll kompatibel zum Boundary Scan Standard wird. Der wesentliche Vorteil der Erfindung besteht darin, dass nunmehr sämtliche Leiterplatten mit Mikroprozessoren, die kein Boundary Scan Register aufweisen, dennoch mit dem effizienterem Boundary Scan Testverfahren getestet werden können. Weiterhin vorteilhaft kann es sein, wenn die Simulation zum voll kompatiblen Baustein gemäß dem Boundary Scan Standard ohne jegliche weitere Hardware im Computer durchgeführt wird.

Die Erfindung wird durch die unabhängigen Ansprüche 1 und 3 definiert.

Die Erfindung soll nachstehend anhand von Ausführungsbeispielen näher erläutert werden. Die dazugehörigen Zeichnungen zeigen:
- Fig. 1: eine schematische Darstellung einer bevorzugten Anordnung der Erfindung
- Fig. 2: eine schematische Darstellung einer weiteren bevorzugten Anordnung der Erfindung

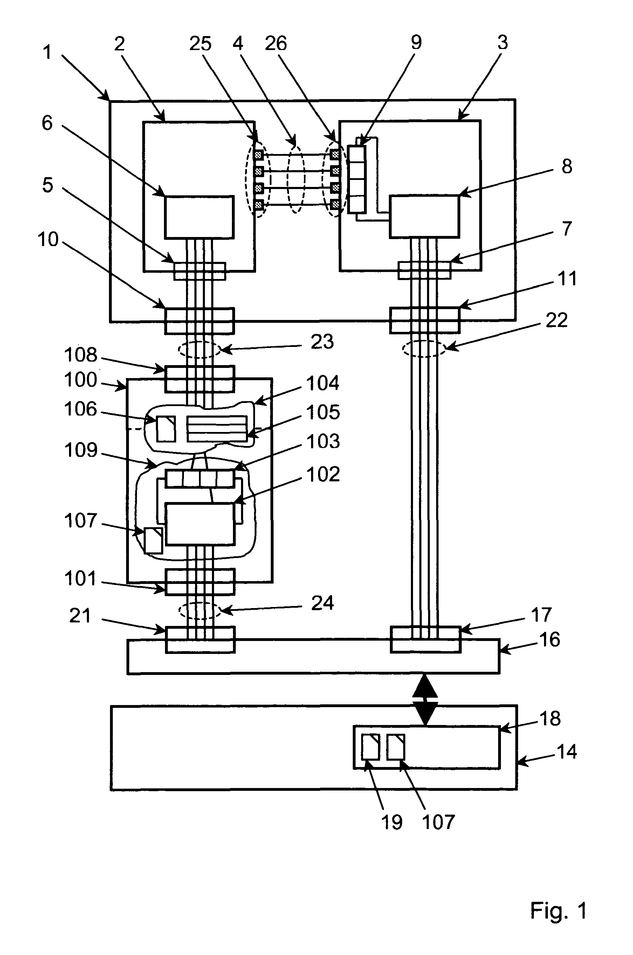

Gemäß Fig. 1 ist die zu prüfende Baugruppe 1 erkennbar, auf der schematisch die wesentlichen Bestandteile nämlich ein Mikroprozessor 2, ein Baustein 3 sowie die Leiterzüge 4 zwischen ihnen angedeutet sind. Der Mikroprozessor 2 weist dabei mindestens einen Test Access Port (bzw. JTAG kompatible Debug Schnittstelle) 5, Anschlusspins 25 und eine Boundary Scan Logik 6, die ihrerseits einen TAP Controller, ein Befehlsregister und mindestens ein Datenregister enthält, auf.

Zur Durchführung des erfindungsgemäßen Verfahrens sind weiterhin ein Adapter 100, eine Boundary Scan Steuereinheit 16 und ein Computer 14 notwendig und gemäß Fig. 1 deshalb dargestellt.

Der Adapter 100 besteht dabei aus einem Test Access Port 101 gemäß dem Boundary Scan Standard. Damit verbunden ist eine Boundary Scan Logik 102, welche ebenfalls gemäß dem Boundary Scan Standard ausgelegt ist und welche einen TAP Controller, ein Befehlsregister sowie mindestens ein Datenregister enthält. Als ein weiteres Datenregister ist das Boundary Scan Register 103 vorhanden. Damit enthält der Adapter 100 alle Komponenten, über die ein Boundary Scan Baustein gemäß dem Boundary Scan Standard verfügen muss, wie z.B. der auf der Baugruppe 1 gezeigte Boundary Scan Baustein 3. Damit ist der Adapter 100 in der Lage, einen solchen Boundary Scan Baustein vollständig zu simulieren.

Weiterhin verfügt der Adapter 100 über eine Logik 104, welche eine Umwandlung der Informationen aus der Boundary Scan Logik 102 und dem Boundary Scan Register 103 in Befehlscode 105 für den Mikroprozessor 2 vornimmt. Diese Umwandlung basiert dabei vorteilhaft auf Basis eines Mikroprozessormodells 106.

Der Adapter verfügt abschließend über eine Schnittstelle 108 zur Ausgabe des Befehlscode 105 über den Testbus 23 zur Schnittstelle 10 der Baugruppe 1.

Die Verfahrensweise zur Erstellung und Durchführung eines Testplans zum Testen der Verbindung 4 zwischen dem Mikroprozessor 2 und dem Boundary Scan Baustein 3 soll nun näher erläutert werden.

Der Grundgedanke der Erfindung besteht darin, dass der Mikroprozessor 2 in einen Boundary Scan Baustein quasi verwandelt wird, um ihn so wie einen Boundary Scan voll kompatiblen Baustein in die Boundary Scan Software 18 einbinden zu können. Somit können die Testmuster zur Überprüfung der Verbindungen 4 vollständig automatisch generiert werden und das zudem ohne die Boundary Scan Software ändern zu müssen.

Boundary Scan Bausteine wie der in Fig. 1 dargestellte Baustein 3 werden in die Boundary Scan Software 18 über eine BSDL Datei 19 (Boundary Scan Description Language) eingebunden. Um also den Mikroprozessor 2 in die Boundary Scan Software 18 einbinden zu können, muss eben solch eine BSDL Datei 107 erzeugt werden. Ein wichtiger Bestandteil dabei ist die Beschreibung des Boundary Scan Registers, welches dann in einem später Schritt in dem Adapter 100 als Boundary Scan Register 103 nachgebildet wird. Das Boundary Scan Register 103 wird dann aus der Kenntnis gewonnen/beschrieben, welche Anschlusspins 25 des Mikroprozessors 2 in welcher Weise gesteuert werden können.

Als ein Beispiel bildet sich ein GPIO Pin (General Purpose Input/Output) welcher eine messende wie auch treibende Funktion erfüllen kann als ein Boundary Scan Pin der Funktion inout ab. Die Vergabe der Boundary Scan Zellen Nummerierung kann dabei willkürlich erfolgen.

Die so erstellte BSDL Datei 107 für den Mikroprozessor 2 wird dem Adapter 100 und genauer der Logik 109 zugeführt. Die Logik 109 konfiguriert sich auf Basis dieser BSDL Datei 107 in der Weise, dass diese am Test Access Port 101 exakt einen Boundary Scan Baustein, wie er mit der BSDL Datei 107 beschrieben wird, simuliert.

Die Erstellung des Testplans zum Testen der Verbindungen 4 erfolgt durch die Boundary Scan Software 18 auf Basis der beiden BSDL Dateien 19 und 107 sowie der CAD Daten der Baugruppe 1. Es werden die in der Boundary Scan Software 18 standardmäßig implementierten Generieralgorithmen benutzt.

Die Abarbeitung des Testplans erfolgt nun in der Weise, dass die Testvektoren von der Boundary Scan Software an die Boundary Scan Hardware 16 geschickt werden. Dabei ist als eine Information enthalten, welche Testvektoren an welcher JTAG Schnittstelle 17 und 21 auszugeben sind. Für den Boundary Scan Baustein 3 werden die Testvektoren verarbeitet, wie dies im Boundary Scan Standard beschrieben ist. Für den Mikroprozessor 2 werden die Testvektoren zunächst über die JTAG Schnittstelle 21 an das Test Access Port 101 des Adapters 100 und von dort über die Boundary Scan Logik 102 in das Boundary Scan Register 103 geschrieben.

Die Logik 104 überwacht ständig den Zustand des TAP Controllers der Boundary Scan Logik 102 (im weiteren TAP Zustand genannt). Mit dem TAP Zustand "DR-Update" werden die Testvektoren im Boundary Scan Register 103 gültig. Dies veranlasst die Logik 104 das Boundary Scan Register 103 auszulesen und Befehlscode 105 für den Mikroprozessor 2 zu generieren und über die Schnittstelle 108 an das Test Access Port 5 des Mikroprozessors 2 zu senden und dort zur Ausführung zu bringen. Der Befehlscode 105 veranlasst den Mikroprozessor 2 dazu die Testvektoren die von der Boundary Scan Software 18 gesendet wurden an dessen Anschlusspins auszugeben.

Die Generierung des Befehlscodes 105 in der Logik 104 erfolgt dabei auf Basis der BSDL Datei 107 des Mikroprozessors 2 und aus Kenntnis der Arbeitsweise des Mikroprozessors 2 idealerweise abgebildet in einem Model 106. So ist es für einen Mikroprozessor üblich, dass ein oder mehrere Register gesetzt werden müssen, um einen vorgegebenen Pegel an einem bestimmten Anschlusspin zu setzen. Ebenso ist aus dem Datenblatt eines Mikroprozessors ersichtlich, wie der Befehlscode lauten muss um Register zu setzen.

Erreicht der TAP Zustand der Boundary Scan Logik 102 den Zustand "DR-Capture", so veranlasst dies die Logik 104 dazu, Befehlscode für den Mikroprozessor 2 zu generieren und an diesen zu schicken, welcher die Pegel an dessen Anschlusspins einliest. Die so ermittelten Informationen werden anschließend gemäß der BSDL Datei 107 im Boundary Scan Register 103 abgelegt und können so gemäß dem Boundary Scan Standard über das Test Access Port 101 ausgelesen werden.

Damit verhält sich der Mikroprozessor 2 durch Zwischenschalten des Adapters 100 in den Testbus 23, 24 aus Sicht der Boundary Scan Software 18 und auch Boundary Scan Steuereinheit 16 genauso als wäre es ein gemäß dem Boundary Scan Standard voll kompatibler Baustein. Etwaige Beschränkungen beim Zugriff auf einzelne Anschlusspins können durch die Einführung der BSDL Datei 107 vollständig berücksichtigt werden.

Für den Anwender ergibt sich damit der Vorteil, dass er seine gesamte Testplan Generierung mit einer einzigen Software 18 macht und das er sich selbst nicht mehr um die Testmuster zum Test der Verbindungen 4 kümmern muss. Die durch die manuelle Synchronisation der Testmuster sonst üblichen auftretenden Fehlerquellen verschwinden damit vollständig. Zudem wird nur noch eine einzige Boundary Scan Steuereinheit 16 benötigt. Die im Stand der Technik notwendige Funktionsteststeuereinheit entfällt somit vollständig.

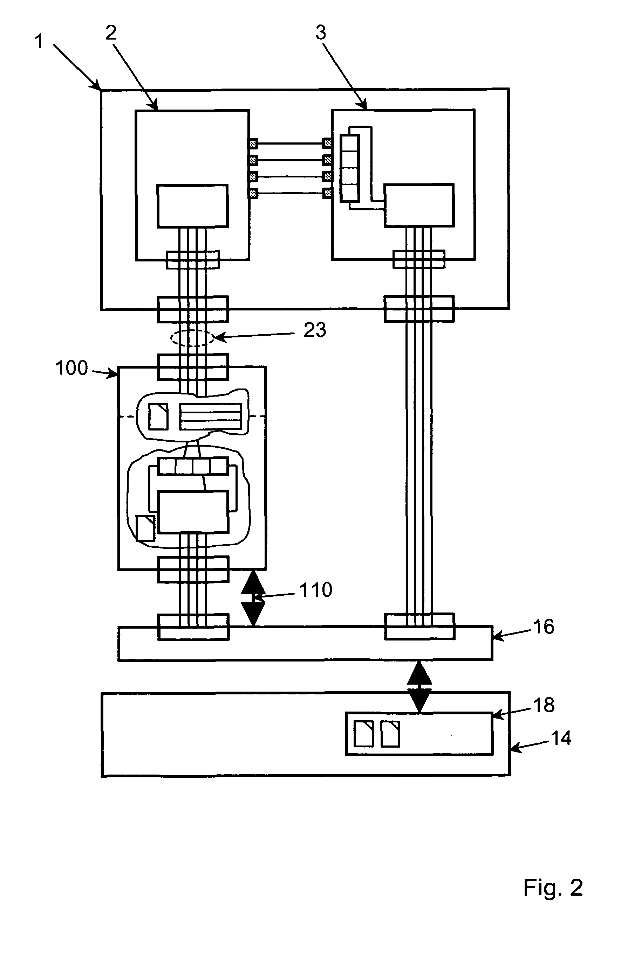

In einer weiteren vorteilhaften Ausführungsform der Erfindung besteht eine zusätzliche Kommunikationsverbindung 110, wie aus Fig. 2 ersichtlich, zwischen dem Adapter 100 und der Boundary Scan Steuereinheit 16. Diese Verbindung kann z.B. dafür genutzt werden, dass der Adapter 100 der Boundary Scan Steuereinheit 16 ein Signal sendet, wenn er einen TAP Zustand fertig verarbeitet hat.

Hierzu ein Beispiel: Der TAP Zustand der Boundary Scan Logik 102 wechselt auf "DR-Capture". Der Boundary Scan Standard besagt hierzu, dass dann mit der nächsten steigenden Flanke des TCK Signals alle Eingänge gleichzeitig gemessen und in das Boundary Scan Register geladen werden. Denn bereits der nächste TAP Zustand ist "DR-Shift" und in diesem Zustand werden die Daten im Boundary Scan Register ausgeschoben.

Die Zeitspanne zwischen dem Pegel/Daten Messen und Ausschieben der Daten ist extrem kurz (maximal ein Viertel der TCK Periode). In dieser kurzen Zeit muss zum Teil sehr viel Befehlscode 105 vom Adapter 100 zum Mikroprozessor 2 nach dem oben beschriebenen Ablauf gesendet und abgearbeitet werden. Das wird nicht in jedem Fall gelingen.

Die eben angesprochene vorteilhafte Ausführungsform der Erfindung würde diese Situation in der Weise verbessern können, dass die Boundary Scan Steuereinheit 16 vor jeder TAP Zustandsänderung wartet, bis ein OK Signal von dem Adapter 100 gesendet wurde. Das OK Signal würde der Adapter 100 immer dann senden, wenn er alle Aktionen die sich aus einer TAP Zustandsänderung ergeben, vollständig verarbeitet hat.

Das gleiche Verhalten ergibt sich beim Erreichen des TAP Zustandes "DR-Update". Hier ist es nur so, dass mit der nächsten fallenden Flanke des TCK Signals die Daten aus dem Boundary Scan Register 103 an den Anschlusspins 25 ausgegeben werden müssen. Laut dem Boundary Scan Standard erfolgt dies an allen Anschlusspins gleichzeitig mit dieser fallenden Flanke des TCK Signals. Auch hier muss über die zusätzliche Kommunikationsverbindung 110 der Boundary Scan Steuereinheit 16 mitgeteilt werden, wenn der Adapter 100 mit der Abarbeitung des TAP Zustandes fertig ist.

Eine weitere vorteilhafte Ausführungsform der Erfindung, gemäß Fig. 2, wird im Folgenden vorgestellt. Im Unterschied zu den vorher genannten Ausführungsformen, wird nun ein vollständiges Programm in den Mikroprozessor 2 geladen. Das Programm arbeitet dabei autark in dem Mikroprozessor 2 und baut eine Kommunikationsverbindung 110 über das Test Access Port 5 auf. Über diese Kommunikationsverbindung 110 werden im Weiteren Daten zwischen dem Adapter 100 und dem Programm ausgetauscht. Bei diesen Daten kann es sich z.B. um den Inhalt des Boundary Scan Registers 103 handeln. Das Programm wird diese Daten interpretieren und daraufhin den entsprechenden Mikroprozessor Befehlscode von sich aus generieren und ausführen.

Der Vorteil der eben erklärten weiteren Ausführungsform der Erfindung liegt darin, dass die Datenmenge, welche über den Testbus 23 übertragen werden muss, wesentlich geringer ausfallen wird.

### Bezugszeichenliste

- 1: Baugruppe
- 2: Mikroprozessor mit JTAG kompatibler Debug Schnittstelle 5
- 3: Baustein voll kompatibel zum Boundary Scan Standard
- 4: Leiterzüge zwischen den Bausteinen 2 und 3
- 5: Test Access Port (JTAG kompatible Debug Schnittstelle)
- 6: Boundary Scan Logik beinhaltet TAP Controller + Befehlsregister + Datenregister
- 7: Test Access Port
- 8: Boundary Scan Logik beinhaltet TAP Controller + Befehlsregister + Datenregister
- 9: Boundary Scan Register
- 10: JTAG Schnittstelle der Baugruppe
- 11: JTAG Schnittstelle der Baugruppe
- 14: Computer
- 16: Boundary Scan Steuereinheit
- 17: JTAG Schnittstelle der Boundary Scan Steuereinheit
- 18: Boundary Scan Software
- 19: Boundary Scan Description Language (BSDL) Datei für den Baustein 3
- 21: JTAG Schnittstelle der Boundary Scan Steuereinheit
- 22: Testbus
- 23: Testbus
- 24: Testbus
- 25: Anschlusspins des Mikroprozessors 2
- 26: Anschlusspins des Boundary Scan Bausteins 3

- 100: Adapter
- 101: Test Access Port
- 102: Boundary Scan Logik beinhaltet TAP Controller + Befehlsregister + Datenregister
- 103: Boundary Scan Register
- 104: Logik zur Umwandlung des Zustandes der Logik 109 in Befehlscode 105
- 105: Befehlscode für den Mikroprozessor 2
- 106: Model des Mikroprozessors 2 für die Logik 104
- 107: Boundary Scan Description Language (BSDL) Datei für den Mikroprozessor 2
- 108: JTAG Schnittstelle des Adapters
- 109: Logik zur Simulation eines Bausteins voll kompatibel zum Boundary Scan Standard
- 110: Kommunikationsverbindung

## Patentansprüche

1. Verfahren zum Steuern von Anschlusspins (25) eines emulationsfähigen Bausteins (2), welcher mindestens einen Test Access Port (5) aufweist und selbst nicht kompatibel zum Boundary Scan Standard ist, mittels eines Computers (14) und einer Boundary Scan Steuereinheit (16), wobei die Anschlusspins (25) über Leiterzüge (4) mit Anschlusspins (26) eines Bausteins (3), der voll kompatibel zum Boundary Scan Standard ist, verbunden sind, **dadurch gekennzeichnet, dass** für Prüfzwecke ein Adapter (100) verwendet wird, der die Funktionen einer Boundary Scan Logik und eines Boundary Scan Registers für den emulationsfähigen Baustein (2) simuliert und den emulationsfähigen Baustein (2) basierend auf den Zuständen der so simulierten Boundary Scan Logik in der Weise über den Test Access Port (5) ansteuert, so dass der emulationsfähige Baustein (2) voll kompatibel zum Boundary Scan Standard wird.

2. Verfahren nach Anspruch 1, **dadurch gekennzeichnet, dass** zwischen der Boundary Scan Steuereinheit (16) und dem emulationsfähigen Baustein (2) der Adapter (100) geschaltet wird, mit dem die Logik zur Nachbildung des Bausteins gemäß dem Boundary Scan Standard erstellt wird, anschließend die Zustände der Logik überwacht werden und in Auswertung der Zustände werden Befehlscodes für den emulationsfähigen Baustein (2) generiert, die in diesem zur Ausführung gebracht werden.

3. Verfahren nach Anspruch 1, **dadurch gekennzeichnet, dass** die Nachbildung der Boundary Scan Logik in dem Computer (14) durchgeführt wird.

4. Anordnung zur Durchführung des Verfahrens nach einem der vorgenannten Ansprüche, wobei eine Baugruppe (1) mit mindestens einem emulationsfähigen Baustein (2), der mindestens einen Test Access Port (5) aufweist und selbst nicht kompatibel zum Boundary Scan Standard ist, und mindestens einem weiteren über Leiterbahnen (4) verbundenen Baustein (3), der voll kompatibel zum Boundary Standard ist, eine Boundary Scan Steuereinheit (16) sowie ein Computer (14) vorhanden sind, **gekennzeichnet dadurch, dass**
- ein Adapter (100) zwischen der Boundary Scan Steuereinheit (16) und dem emulationsfähigen Baustein (2) angeordnet ist,
- der Adapter eine Logik (109) und eine nachgeschaltete Logik (104) zur Umwandlung des Zustandes der Logik (109) aufweist,
- die Logik (109) eine Boundary Scan Logik (102) mit einem TAP Controller, einem Befehlsregister sowie mindestens ein Datenregister und ein weiteres Boundary Scan Register (103) enthält,
- die Logik (104) Befehlscode (105) in Abhängigkeit der Logik (109) für den emulationsfähigen Baustein (2) erzeugt.

5. Anordnung nach Anspruch 4, **dadurch gekennzeichnet, dass** der Befehlscode (105) so generiert ist, dass der emulationsfähige Baustein (2) an seinen Ausgangspins die Testmuster ausgibt, die er ausgeben würde, wenner kompatibel zu dem Boundary Scan Standard wäre.

6. Anordnung nach Anspruch 4 oder 5, **dadurch gekennzeichnet, dass** der Adapter (100) integraler Bestandteil der Boundary Scan Steuereinheit (16) ist.

7. Anordnung nach einem der Ansprüche 4 bis 6, **dadurch gekennzeichnet, dass** der Adapter (100) über eine zusätzliche Kommunikationsverbindung (110) zur Boundary Scan Steuereinheit (16) verfügt.

## Claims

1. Method for controlling connection pins (25) of an emulation-capable component (2), having at least one Test Access Port (5) and being incompatible with the Boundary-Scan standard, by means of a computer (14) and a Boundary-Scan control unit (16), wherein the connection pins (25) are connected to connection pins (26) of a component (3) via conductor tracks (4), said component (3) being fully compatible with the Boundary-Scan standard, **characterized in that** an adapter (100) is used for testing purposes which simulates the functions of a Boundary-Scan logic and of a Boundary-Scan register for the emulation-capable component (2) and controls the emulation-capable component (2) via the Test Access Port (5) based on the states of the Boundary-Scan logic simulated in this way, so that the emulation-capable component (2) becomes fully compatible with the Boundary-Scan standard.

2. Method according to claim 1, **characterized in that** the adapter (100), by means of which the logic for simulating the component according to the Boundary-Scan standard is created, is connected between the Boundary-Scan control unit (16) and the emulation-capable component (2), then the states of the logic are monitored, and after evaluating the states command codes are generated for the emulation-capable component (2), said command codes being executed in said emulation-capable component (2).

3. Method according to claim 1, **characterized in that** the simulation of the Boundary-Scan logic is executed in the computer (14).

4. Arrangement for executing the method according to one of the preceding claims, wherein an assembly (1) with at least one emulation-capable component (2), having at least one Test Access Port (5) and being incompatible with the Boundary-Scan standard, and at least one further component (3), being connected via conductor paths (4) and being fully compatible with the Boundary standard, a Boundary-Scan control unit (16) and a computer (14) are provided, **characterized in that**
- an adapter (100) is arranged between the Boundary-Scan control unit (16) and the emulation-capable component (2),
- the adapter has a logic (109) and a logic (104) which is arranged downstream of the logic (109) for transforming the state of the logic (109),
- the logic (109) contains a Boundary-Scan logic (102) with a TAP controller, a command register and at least one data register and one further Boundary-Scan register (103),
- the logic (104) generates a command code (105) for the emulation-capable component (2) depending on the logic (109).

5. Arrangement according to claim 4, **characterized in that** the command code (105) is generated in such a way that, at its output pins, the emulation-capable component (2) outputs the test patterns which it would output if it was compatible with the Boundary-Scan standard.

6. Arrangement according to claim 4 or 5, **characterized in that** the adapter (100) is an integral part of the Boundary-Scan control unit (16).

7. Arrangement according to one of claims 4 to 6, **characterized in that** the adapter (100) has an additional communication link (110) to the Boundary-Scan control unit (16).

## Revendications

1. Procédé de commande de broches de connexion (25) d'un composant (2) pouvant émuler, ayant au moins un Test Access Port (5) et étant incompatible avec le standard Boundary-Scan, au moyen d'un ordinateur (14) et d'une unité de commande Boundary-Scan (16), les broches de connexion (25) étant reliées à des broches de connexion (26) d'un composant (3) via des pistes conductrices (4), ledit composant (3) étant entièrement compatible avec le standard Boundary-Scan, **caractérisé en ce qu'**à des fins de test, un adaptateur (100) est utilisé qui simule les fonctions d'une logique Boundary-Scan and d'un registre Boundary-Scan pour le composant (2) pouvant émuler et qui commande le composant (2) pouvant émuler via le Test Access Port (5) sur la base des états de la logique Boundary-Scan simulée de cette façon, afin que le composant (2) pouvant émuler devienne entièrement compatible avec le standard Boundary-Scan.

2. Procédé selon la revendication 1, **caractérisé en ce que** l'adaptateur (100), par lequel la logique pour simuler le composant selon le standard Boundary-Scan est crée, est installé entre l'unité de commande Boundary-Scan (16) et le composant (2) pouvant émuler, puis les états de la logique sont surveillés et après évaluer les états des codes de commande sont générés pour le composant (2) pouvant émuler, lesdits codes de commande étant exécutés dans ce composant (2) pouvant émuler.

3. Procédé selon la revendication 1, **caractérisé en ce que** la simulation de la logique Boundary-Scan est exécutée dans l'ordinateur (14).

4. Agencement d'exécution du procédé selon une des revendications précédentes, dans lequel sont fournis un assemblage (1) avec au moins un composant (2) pouvant émuler, ayant au moins un Test Access Port (5) et étant incompatible avec le standard Boundary-Scan, et au moins un autre composant (3), qui est relié via des lignes conductrices (4) et qui est entièrement compatible avec le standard Boundary, une unité de commande Boundary-Scan (16) et un ordinateur (14), **caractérisé en ce que**
- un adaptateur (100) est disposé entre l'unité de commande Boundary-Scan (16) et le composant (2) pouvant émuler,
- l'adaptateur a une logique (109) et une logique (104) qui est reliée en aval de la logique (109) pour transformer l'état de la logique (109),
- la logique (109) contient une logique Boundary-Scan (102) avec un contrôleur TAP, un registre de commande et au moins un registre de données et un autre registre Boundary-Scan (103),
- la logique (104) génère un code de commande (105) pour le composant (2) pouvant émuler en fonction de la logique (109).

5. Agencement selon la revendication 4, **caractérisé en ce que** le code de commande (105) est généré de telle façon que, à ses broches de sortie, le composant (2) pouvant émuler émette les modèles de test qu'il émettrait s'il était compatible avec le standard Boundary-Scan.

6. Agencement selon la revendication 4 ou 5, **caractérisé en ce que** l'adaptateur (100) est une partie intégrante de l'unité de commande Boundary-Scan (16).

7. Agencement selon une des revendications 4 à 6, **caractérisé en ce que** l'adaptateur (100) a une liaison de communication supplémentaire (110) à l'unité de commande Boundary-Scan (16).
